# EUROPEAN PATENT APPLICATION

(11) **EP 4 601 273 A1**
(43) Date of publication of application: **13.08.2025**
(21) Application number: 23875158.0
(22) Date of filing: 26.09.2023
(51) Int. Cl.: H04M 1/02, G06F 1/16, F16F 1/02, G09F 9/30, G06F 3/041, H10K 50/84, H10K 102/00

(54) **ELASTIC MEMBER MODULE AND ELASTIC MEMBER**

(30) Priority: 07.10.2022 KR 20220128409; 14.10.2022 KR 20220132087; 27.10.2022 KR 20220139918
(71) Applicant: LG Innotek Co., Ltd., Seoul 07796 (KR)
(72) Inventor: KANG, Sung Won, Seoul 07796 (KR); GWAK, Jung Min, Seoul 07796 (KR); KO, Sang Jun, Seoul 07796 (KR); YANG, Joon Hyuk, Seoul 07796 (KR)
(74) Representative: Plasseraud IP
(86) International application number: PCT/KR2023/014921
(87) International publication number: WO 2024/076093

(57) **Abstract**

An elastic member module according to an embodiment includes an elastic member and a frame, wherein the elastic member and the frame are connected by a bridge part, the elastic member includes a cutting region, the cutting region includes a first concave portion, a second concave portion, and a connection part between the first concave portion and the second concave portion, the first concave portion and the second concave portion are formed in a concave shape with respect to an outer surface of the elastic member, and the connection part is connected to the bridge part.

## Description

### [Technical Field]

An embodiment relate to elastic member modules and elastic members.

### [Background Art]

Recently, a demand for foldable display devices capable of displaying images on a large screen is increasing.

The foldable display is folded or partially bent when carried. In addition, the foldable display is unfolded when displaying an image. This increases an image display region while facilitating portability for the user.

The foldable display device repeats a restoration process of folding or bending and then unfolding it again.

Therefore, the foldable display device includes an elastic member capable of folding.

The elastic member includes a folding region and an unfolding region. The elastic member can be bent before being applied to the display device. Therefore, the elastic member is coupled with a frame and stored. When the elastic member is applied to the display device, the elastic member and the frame are separated.

The elastic member includes a bridge part. The bridge part is connected to the frame. When the elastic member and the frame are cut, the bridge part is cut. At this time, a part of the bridge part may remain. A remaining region of the bridge part protrudes outward from the elastic member. Accordingly, stability problems may occur when handling the elastic member. In addition, a bezel region of the elastic member increases.

Therefore, a new elastic member structure that can solve the above problems is required.

### [Disclosure]

### [Technical Problem]

An embodiment provides an elastic member capable of improving stability of a user.

An embodiment provides an elastic member with reduced bezel region.

### [Technical Solution]

An elastic member module according to an embodiment includes an elastic member and a frame, wherein the elastic member and the frame are connected by a bridge part, the elastic member includes a cutting region, the cutting region includes a first concave portion, a second concave portion, and a connection part between the first concave portion and the second concave portion, the first concave portion and the second concave portion are formed in a concave shape with respect to an outer surface of the elastic member, and the connection part is connected to the bridge part.

### [Advantageous Effects]

The elastic member module according to the embodiment includes patterns connected to a connection part.

The patterns are formed in a concave shape with respect to an outer surface of the elastic member. Accordingly, the bridge part can be cut at an inner side of the outer surface of the elastic member.

Therefore, a cutting surface of the bridge part is disposed at an inner side of the outer surface of the elastic member.

Therefore, the cutting surface of the elastic member does not protrude beyond the outer surface of the elastic member.

Therefore, a safety accident caused by a protruding region remaining after cutting the bridge can be prevented.

In addition, since the protruding part is removed, a size of a bezel region of the elastic member is reduced.

### [Description of Drawings]

FIG. 1 is a perspective view of a display device according to an embodiment.
FIG. 2 is a perspective view of an elastic member according to an embodiment.
FIG. 3 is a side view of an elastic member according to an embodiment before folding.
FIG. 4 is a side view of an elastic member according to an embodiment after folding.
FIG. 5 is a plan view of an elastic member module including an elastic member according to an embodiment.
FIG. 6 is an enlarged view of region A of FIG. 5.
FIG. 7 is a drawing showing cutting lines of an elastic member and a bridge part in an enlarged view of region A of FIG. 5.
FIG. 8 and FIG. 9 are drawings showing an elastic member after the bridge part is cut in an enlarged view of region A of FIG. 5.
FIG. 10 and FIG. 11 are top views of an elastic member according to an embodiment.
FIG. 12 is another enlarged view of region A of FIG. 5.
FIG. 13 is a cross-sectional view taken along line B-B' of FIG. 12.
FIG. 14 is a drawing showing a bridge part cut in an overlapping region of FIG. 13.
FIG. 15 and FIG. 16 are top views of an elastic member according to a second embodiment.
FIG. 17 is a top view of an elastic member according to a third embodiment.
FIG. 18 is a top view of an elastic member module in which an elastic member and a frame are combined according to a third embodiment.
FIG. 19 to FIG. 21 are drawings for explaining reliability of an elastic member according to a position of a protruding part of an embodiment and a comparative example.
FIG. 22 to FIG. 25 are top views of an elastic member according to another embodiment of a third embodiment.
FIG. 26 is a cross-sectional view of a folding support including an elastic member according to an embodiment.
FIG. 27 is a cross-sectional view of a display device including a flexible support according to an embodiment.
FIG. 28 is a drawing for explaining an application example of a display device according to an embodiment.

### [Mode for Invention]

Hereinafter, embodiments of the present disclosure will be described in detail with reference to the accompanying drawings. However, the spirit and scope of the present disclosure is not limited to a part of the embodiments described, and may be implemented in various other forms, and within the spirit and scope of the present disclosure, one or more of the elements of the embodiments may be selectively combined and redisposed.

In addition, unless expressly otherwise defined and described, the terms used in the embodiments of the present disclosure (including technical and scientific terms) may be construed the same meaning as commonly understood by one of ordinary skill in the art to which the present disclosure belongs, and the terms such as those defined in commonly used dictionaries may be interpreted as having a meaning that is consistent with their meaning in the context of the relevant art.

In addition, the terms used in the embodiments of the present disclosure are for describing the embodiments and are not intended to limit the present disclosure. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present disclosure, the terms such as first, second, A, B, (a), and (b) may be used. These terms are only used to distinguish the elements from other elements, and the terms are not limited to the essence, order, or order of the elements.

In addition, when an element is described as being "connected", "coupled", or "contacted" to another element, it may include not only when the element is directly "connected" to, "coupled" to, or "contacted" to other elements, but also when the element is "connected", "coupled", or "contacted" by another element between the element and other elements.

In addition, when described as being formed or disposed "on (over)" or "under (below)" of each element, the "on (over)" or "under (below)" may include not only when two elements are directly connected to each other, but also when one or more other elements are formed or disposed between two elements.

Hereinafter, an elastic member, a folding support, and a display device according to an embodiment will be described with reference to the drawings.

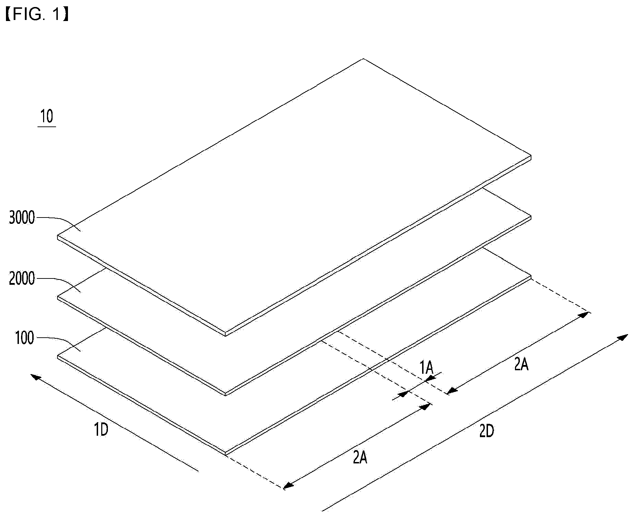

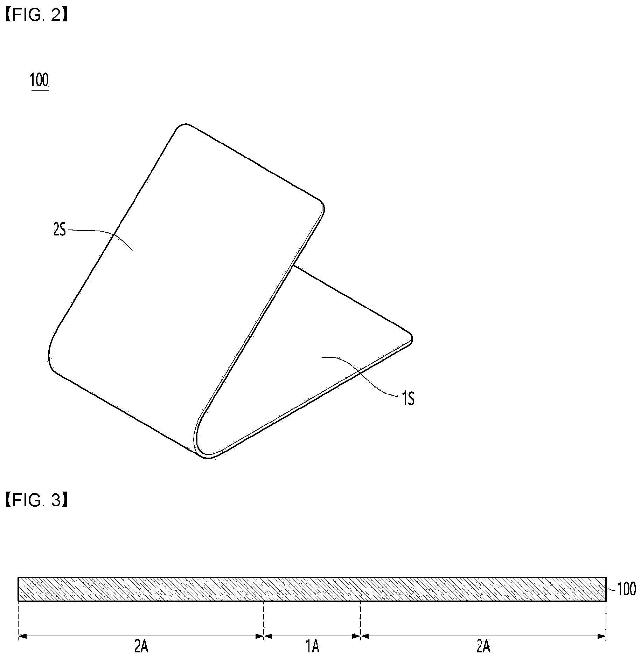

FIG. 1 is a perspective view of a display device according to an embodiment. FIGS. 2 to 4 are perspective views and cross-sectional views of an elastic member according to an embodiment.

Referring to FIG. 1, a display device 10 may include an elastic member 100, a display panel 2000 and a touch panel 3000 disposed on the elastic member 100.

The elastic member 100 supports the display panel 2000 and the touch panel 3000. That is, the elastic member 100 may be a supporting substrate.

The touch panel 3000 and the display panel 2000 may be formed integrally. For example, the touch panel 3000 may be formed integrally with the display panel 2000 in an on-cell or in-cell manner.

The elastic member 100 may include a metal material and a non-metal material. In detail, the elastic member 100 may be formed of a plurality of layers. The plurality of layers may include at least one of the metal material and the non-metal material. For example, the elastic member 100 may include a metal, a metal alloy, a plastic, a composite material (e.g., a carbon fiber reinforced plastic, a magnetic or conductive material, a glass fiber reinforced material), a ceramic, sapphire, or glass.

The elastic member 100 may be flexible or foldable. That is, the elastic member 100 may be bent in one direction. That is, the elastic member 100 may be a display substrate applied to a flexible display device or a foldable display device.

The elastic member 100 is defined in a first direction 1D and a second direction 2D. For example, the first direction 1D may be a folding axis direction of the elastic member 100. The second direction 2D may be perpendicular to the first direction.

One of the first direction 1D and the second direction 2D is a width direction of the elastic member 100, and other direction is a length direction of the elastic member 100.

The elastic member 100 is folded with the first direction 1D or the second direction 2D as a folding axis.

Hereinafter, the first direction 1D is defined as the folding axis direction. In addition, the first direction is defined as a width direction of the elastic member 100. In addition, the second direction is defined as a length direction of the elastic member 100.

The elastic member 100 may include at least two regions. In detail, the elastic member 100 includes a first region 1A and a second region 2A.

The first region 1A is a region where the elastic member 100 is folded. In addition, the second region 2A is a region where the elastic member 100 is not folded. That is, the first region 1A is a folding region, and the second region 2A is an unfolding region.

The display panel 2000 is disposed on the elastic member 100.

The display panel 2000 may include a plurality of pixels including a switching thin film transistor, a driving thin film transistor, a capacitor, and an organic light emitting diode (OLED).

The touch panel 3000 is disposed on the display panel 2000. The display device has a touch function by the touch panel 3000. A display device that only displays an image may omit the touch panel.

The touch panel 3000 includes a substrate and a touch electrode disposed on the substrate. The touch electrode is driven by a capacitive method or a resistive film method.

When the touch panel 3000 and the display panel 2000 are formed integrally, a thickness of the display device may be reduced.

The elastic member 100 and the display panel 2000 may have different sizes.

For example, an area of the elastic member 100 may be 90% to 110% of an area of the display panel 2000. In detail, the area of the elastic member 100 may be 95% to 105% of the area of the display panel 2000. In more detail, the area of the elastic member 100 may be 97% to 100% of the area of the display panel 2000.

If the area of the elastic member 100 is less than 90% of the area of the display panel 2000, a support force of the elastic member 100 decreases. Accordingly, curling may occur in the unfolding region of the elastic member 100.

In addition, if the area of the elastic member 100 exceeds 110% of the area of the display panel 2000, a bezel region of the display device increases.

Although not shown in the drawing, the display device may further include a cover window. The cover window is disposed on the touch panel 3000. Alternatively, when the touch panel is omitted, the cover window is disposed on the display panel 2000. The cover window protects the display device.

The elastic member 100, the display panel 2000, and the touch panel 3000 are bonded by an adhesive layer.

As described above, the display device includes the elastic member 100.

Referring to FIGS. 2 to 4, the elastic member 100 can be bent in one direction.

The elastic member 100 includes a first surface 1S and a second surface 2S. The first surface 1S and the second surface 2S are opposite surfaces. The elastic member 100 can be bent so that the first surface 1S faces each other. That is, the elastic member 100 can be bent so that a surface on which the panels are disposed faces each other. Alternatively, the elastic member 100 can be bent so that the second surface 2S faces each other. That is, the elastic member 100 can be bent so that an opposite surface of a surface on which the panels are disposed faces each other.

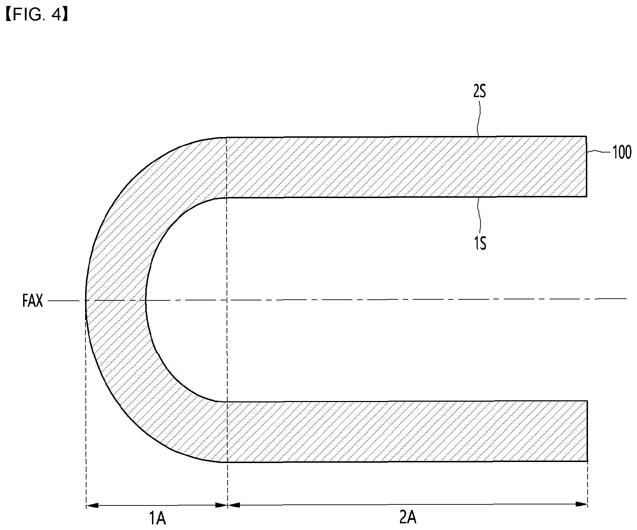

In the following description, it is described that the first surfaces 1S are bent in a direction facing each other as in FIG. 4.

The first region 1A and the second region 2A are regions defined when the elastic member 100 is bent.

In detail, the first region 1A is a folding region, and the second region is an unfolding region.

Referring to FIGS. 3 and 4, the elastic member 100 includes the first region 1A and the second region 2A.

For example, the second region 2A can be formed at left and right sides of the first region 1A, respectively. That is, the second region 2A can be disposed at both ends of the first region 1A. That is, the first region 1A can be disposed between the second regions 2A.

However, the embodiment is not limited thereto, and the first region 1A may be further formed at an outside of the second region 2A.

Sizes of the first region 1A and the second region 2A may be different. In detail, the size of the second region 2A is larger than the size of the first region 1A.

In addition, the area of the first region 1A may be 1% to 30% of a total area of the elastic member 100. In detail, the area of the first region 1A may be 5% to 20% of the total area of the elastic member 100. The area of the first region 1A may be 10% to 15% of the total area of the elastic member 100.

If the area of the first region 1A is less than 1% of the total area of the elastic member 100, a crack may occur at a boundary between the folding region and the unfolding region of the elastic member. Accordingly, the folding reliability of the elastic member 100 is reduced.

In addition, if the area of the first region 1A exceeds 30% of the total area of the elastic member 100, a curl may occur at the folding region of the display panel 2000.

FIG. 4 is a side view of a folded elastic member.

Referring to FIG. 4, the elastic member 100 is folded in one direction centered on a folding axis FAX. In detail, the elastic member 100 is folded in a direction in which the first surfaces 1S face each other along the folding axis FAX.

Accordingly, the elastic member 100 may be formed with a first region 1A and a second region 2A. That is, the elastic member 100 may be formed with a folding region and an unfolding region.

The folding region is a region where a curvature (R) is formed. The unfolding region is a region where a curvature (R) is not formed. Alternatively, the unfolding region is a region where a curvature is close to 0.

Referring to FIGS. 3 and 4, the elastic member 100 may be folded in one direction, and may be formed in an order of an unfolding region, a folding region, and an unfolding region.

A plurality of pattern parts may be formed in at least one region of the first region 1A and the second region 2A. The pattern part reduces and disperses stress generated when the elastic member 100 folds. The pattern part is described in detail below.

FIG. 4 illustrates that the curvature decreases while extending from a center of the folding axis. However, the embodiment is not limited thereto. For example, the curvature may decrease and increase while extending from the center of the folding axis. That is, the curvature may decrease and then increase while extending from a center of the folding axis. Alternatively, the curvature may decrease and then increase while extending from a center of the folding axis, and then decrease again. That is, a folding shape of the elastic member 100 may be formed in various shapes other than a U-shape.

The elastic member 100 has a thin thickness. Accordingly, the elastic member 100 may be bent in one direction. Accordingly, the elastic member is combined with the frame 200 before being applied to the display device. That is, an elastic member module 1000 in which the elastic member 100 and the frame 200 are combined is manufactured. When the elastic member 100 is applied to the display device, the elastic member 100 and the frame 200 are separated.

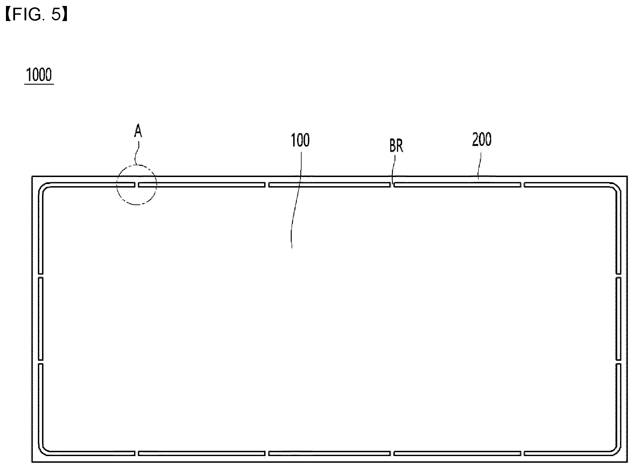

FIG. 5 is a plan view of an elastic member module 1000.

Referring to FIG. 5, the elastic member module 1000 includes an elastic member 100, a frame 200, and a bridge part BR. The elastic member 100 and the frame 200 are connected by the bridge part BR. In detail, the elastic member 100 and the frame 200 are separated by a hole H. In addition, the elastic member 100 and the frame 200 are connected by the bridge part BR.

The elastic member 100 and the frame 200 may include a same material. The elastic member 100 and the frame 200 are distinguished by the bridge part BR.

The bridge part BR is disposed at an outside of the elastic member 100. In detail, a plurality of bridge parts BR are disposed at an edge of the elastic member 100.

The bridge part BR has a set width and length. The width of the bridge part BR may increase while extending from the elastic member 100 to the frame 200.

The bridge part BR is a region where the elastic member 100 and the frame 200 are connected. In addition, the bridge part BR is a region that separates the elastic member 100 and the frame 200. For example, when a force is applied to one region of the bridge part BR, the bridge part BR is cut, and thus, the elastic member 100 and the frame 200 are separated.

After the elastic member 100 is separated, a part of the bridge part BR may remain at an edge of the elastic member 100. That is, a part of the bridge part BR may remain in a state of being combined with the elastic member 100.

Therefore, a remaining part of the bridge part BR protrudes outwardly from the elastic member 100. Accordingly, when a user handles the elastic member 100, a safety issue may occur due to the remaining part. In addition, a bezel region of the elastic member 100 may increase due to the remaining part.

To solve this problem, the elastic member according to the embodiment changes a cutting region of the bridge part. As a result, the elastic member can remove the remaining part of the bridge part.

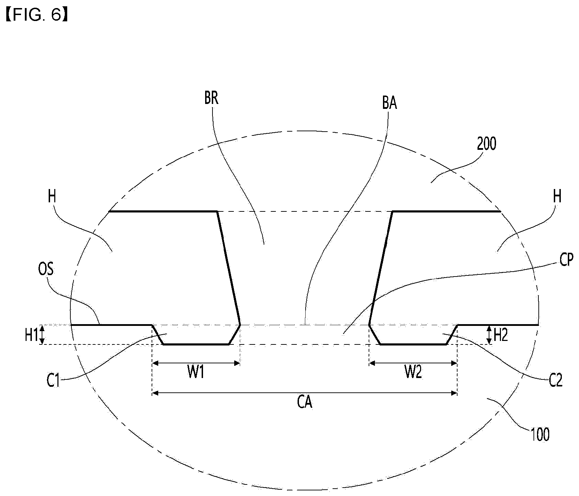

FIGS. 6 to 9 are drawings for explaining the elastic member and the bridge part before and after cutting.

Referring to FIG. 6, the elastic member 100 includes a cutting region CA. The cutting region CA is a region where the elastic member 100 is cut from the bridge part BR.

The cutting region CA includes a first concave portion C1, a second concave portion C2, and a connection part CP.

The first concave portion C1 and the second concave portion C2 may be formed in a concave shape with respect to an outer surface OS of the elastic member. In detail, the first concave portion C1 and the second concave portion C2 may be formed by etching the outer surface OS in a concave shape. Accordingly, a width of the elastic member of a region including the first concave portion C1 and the second concave portion C2 may be smaller than a width of the elastic member of another region.

The connection part CP is disposed between the first concave portion C1 and the second concave portion C2. The connection part CP is one region of the elastic member 100. The connection part CP is adjacent to the first concave portion C1 and the second concave portion C2. In detail, the connection part CP is connected to the first concave portion C1 and the second concave portion C2.

The connection part CP is a region where the elastic member 100 and the bridge part BR are connected. Accordingly, the connection part CP and the bridge part BR can form a boundary region BA.

The elastic member 100 and the bridge part BR are cut at the connection part CP. In detail, the elastic member 100 is separated from the bridge part BR by the first concave portion C1 and the second concave portion C2.

In detail, a space in which the connection part CP can be cut is formed by the first concave portion C1 and the second concave portion C2. The connection part CP is cut using the space.

The first concave portion C1 and the second concave portion C2 have a set size. In detail, the first concave portion C1 has a first width W1. The second concave portion C2 has a second width W2.

The first width W1 and the second width W2 may be 30% or less of a width of the cutting region CA. In detail, the first width W1 and the second width W2 may be 15% to 30%, 18% to 28%, or 23% to 27% of a width of the cutting region CA.

The first width W1 and the second width W2 may be the same or similar within the above range.

When the first width W1 and the second width W2 exceed 30% of the width of the cutting region CA, a width of a region where the connection part CP and the bridge part BR are connected decreases. Therefore, a bonding force between the elastic member 100 and the frame 200 decreases. Accordingly, when handling the elastic member 100, the elastic member 100 and the frame 200 may be separated.

If the first width W1 and the second width W2 are less than 15% of the width of the cutting region CA, the widths of the first width W1 and the second width W2 become too small. Therefore, when cutting the connection part CP, a region other than the connection part CP may be cut together. Accordingly, the reliability of the elastic member 100 may decrease.

For example, the first width W1 and the second width W2 may be 0.5 mm or less, 0.4 mm or less, 0.3 mm or less, or 0.2 mm or less.

The first concave portion C1 has a first height H1. The second concave portion C2 has a second height H2.

The first height H1 may be smaller than the first width W1. The second height H2 may be smaller than the second width W2. In detail, the first height H1 may be 40% or less of the first width W1. In detail, the first height H1 may be 20% to 40%, 25% to 35%, or 27% to 33% of the first width W1.

In addition, the second height H2 may be 20% to 40%, 25% to 35%, or 27% to 33% of the second width W2.

The first height H1 and the second height H2 may be the same or similar within the above range.

If each of the first height H1 and the second height H2 exceeds 40% of the first width W1 and the second width W2, the sizes of the first concave portion C1 and the second concave portion C2 increase. Accordingly, a strength of the elastic member may decrease. In addition, a bezel region of the elastic member may increase.

In addition, if each of the first height H1 and the second height H2 are less than 20% of the first width W1 and the second width W2, the sizes of the first concave portion C1 and the second concave portion C2 decrease. Accordingly, the height of the connection part CP also decreases. Accordingly, a cutting area of the connection part CP decreases. Therefore, the elastic member and the bridge part cannot be easily cut. Alternatively, a defect may occur during the cutting process.

For example, the first height H1 and the second height H2 may be 0.2 mm or less, 0.15 mm or less, or 0.1 mm.

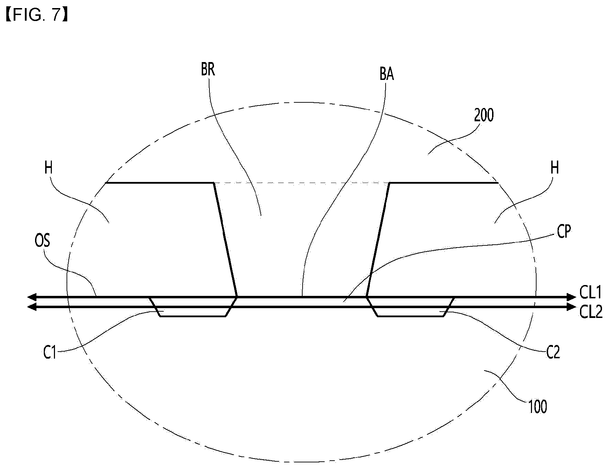

The connection part CP may be cut in various regions. Referring to FIG. 7, the connection part CP may be cut in a boundary region BA by a first cutting line CL1. Alternatively, the connection part CP may be cut by a second cutting line CL2 at a lower portion of the boundary region BA.

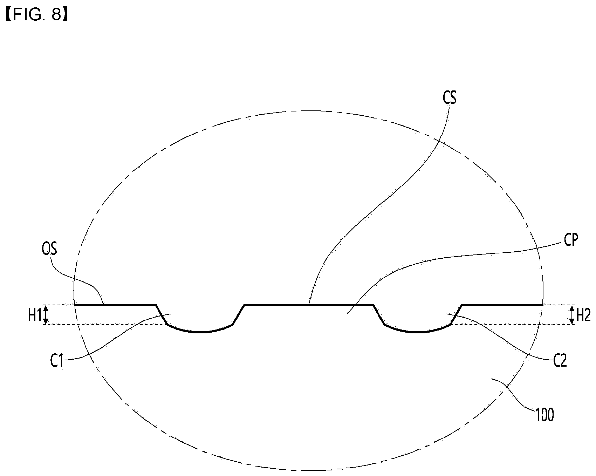

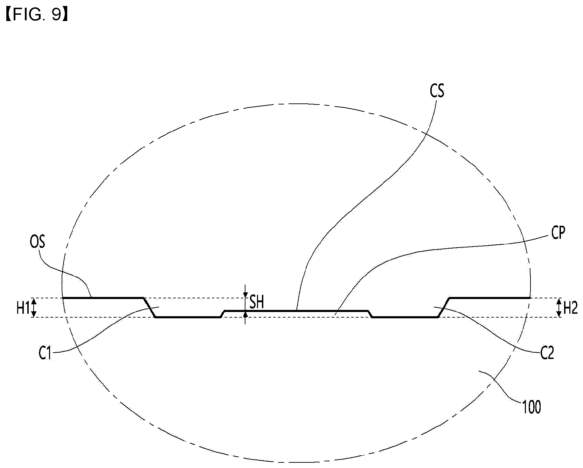

Accordingly, referring to FIGS. 8 and 9, a cutting surface CS of the elastic member 100 may be parallel to the outer surface OS of the elastic member 100 or may have a step SH.

When the connection part CP and the bridge part BR are cut by the first cutting line CL1, the cutting surface CS and the outer surface OS may be parallel.

Alternatively, when the connection part CP and the bridge part BR are cut by the second cutting line CL2, the cutting surface CS and the outer surface OS may have a step SH. That is, the cutting surface CS and the outer surface OS may have different heights. In detail, the height of the cutting surface CS is lower than the height of the outer surface OS. By this, a step is formed.

Therefore, when the elastic member and the bridge part are separated, a protruding region due to a remaining region of the bridge part is removed. That is, the cutting surface CS is disposed parallel to the outer surface of the elastic member or at a low height. Accordingly, a remaining portion of the bridge part can be prevented from protruding outwardly of the elastic member.

Therefore, a safety of the user is improved. In addition, a bezel region of the elastic member can be prevented from increasing due to the protruding region.

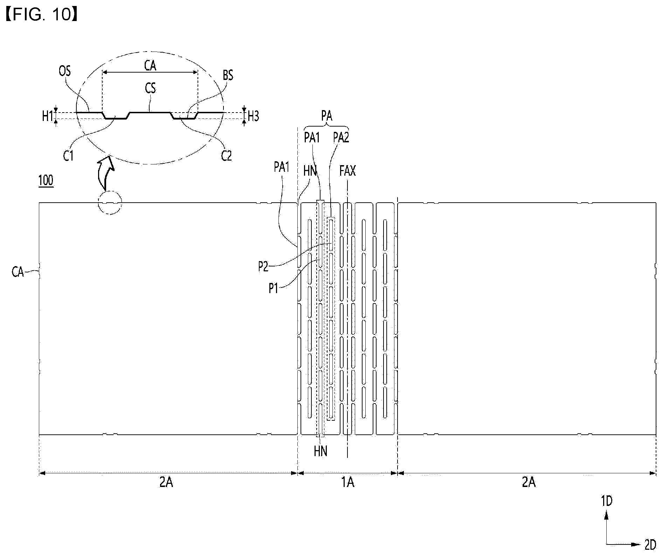

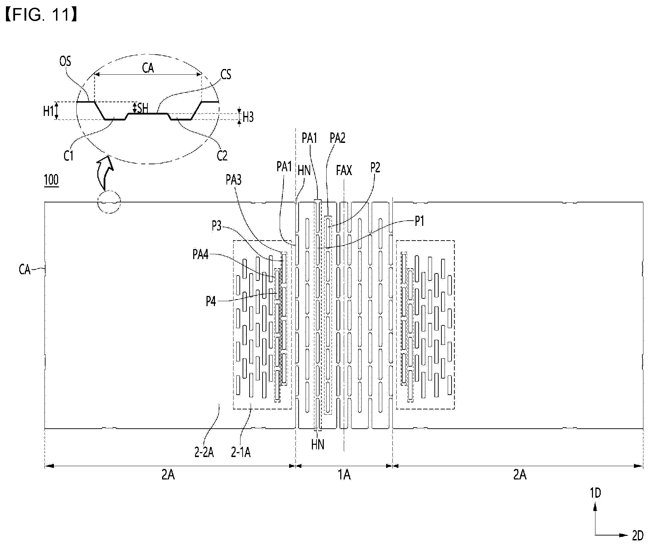

Hereinafter, with reference to FIGS. 10 and 11, the elastic member separated from the frame will be described.

FIGS. 10 and 11 are top views of the elastic member 100.

The elastic member 100 includes a first region 1A and a second region 2A. The first region 1A is folded in one direction. In addition, the second region 2A is not folded. Alternatively, some regions of the second region 2A may be folded, and other regions may not be folded.

For example, the second region 2A may include a second-first region 2-1A and a second-second region 2-2A. In detail, the second-first region 2-1A is a region where a pattern is formed. The second-second region 2-2A is a region where a pattern is not formed. The second-first region 2-1A is a boundary region between the folding region and the unfolding region.

Widths of the first region 1A and the second region 2A are different. In detail, the width of the first region 1A is smaller than the width of the second region 2A. The width of the first region 1A is a width of the second direction 2D. For example, the width of the first region 1A may be 15 mm to 30 mm, 18 mm to 27 mm, or 20 mm to 25 mm.

The elastic member includes a pattern part including a plurality of patterns. The pattern part is disposed in the first region 1A and the second region 2A. For example, as in FIG. 10, the pattern part may be disposed only in the first region. Alternatively, as in FIG. 11, the pattern part may be disposed in both the first region 1A and the second region 2A.

For example, a first pattern part PA1 and a second pattern part PA2 may be disposed in the first region 1A. The first pattern part PA1 includes a plurality of first patterns P1 spaced apart in the first direction. The second pattern part PA2 includes a plurality of second patterns P2 spaced apart in the first direction.

A third pattern part PA3 and a fourth pattern part PA4 may be disposed in the second region 2A. The third pattern part PA3 includes a plurality of third patterns P3 spaced apart in the first direction. The fourth pattern part PA4 includes a plurality of fourth patterns P4 spaced apart in the first direction.

The first pattern part PA1 and the second pattern part PA2 are disposed in the first region 1A. The third pattern part PA3 and the fourth pattern part PA4 are disposed in the second-first region 2-1A.

The first pattern parts PA1 are spaced apart in the second direction 2D. In addition, the second pattern parts PA2 are spaced apart in the second direction 2D. In addition, the first pattern part PA1 and the second pattern part PA2 are spaced apart in the second direction 2D. In addition, the first pattern part PA1 and the second pattern part PA2 are alternately disposed.

The first pattern P1 and the second pattern P2 face each other in the second direction 2D. For example, the first pattern P1 and the second pattern P2 partially overlap in the second direction 2D. For example, the first pattern P1 and the second pattern P2 are disposed in a zigzag shape.

However, the embodiment is not limited thereto. The first pattern P1 and the second pattern P2 may entirely overlap in the second direction 2D.

The first pattern P1 and the second pattern P2 are formed by penetrating the elastic member 100. For example, the first pattern P1 and the second pattern P2 completely penetrate the elastic member 100. Accordingly, the first pattern P1 and the second pattern P2 may be formed in a hole shape. Alternatively, the first pattern P1 and the second pattern P2 partially penetrate the elastic member 100. Accordingly, the first pattern P1 and the second pattern P2 may be formed in a groove shape.

The first pattern part PA1 and the second pattern part PA2 reduce and disperse stress generated by folding. Accordingly, when the elastic member is folded, the first region 1A may be prevented from being deformed.

A length (length in the first direction) of at least one of the first pattern P1 and the second pattern P2 may be 2 mm to 5 mm, 3 mm to 4 mm, or 3.3 mm to 3.8 mm. In addition, a width (width in the second direction) of at least one of the first pattern P1 and the second pattern P2 may be 0.1 mm to 0.3 mm, 0.15 mm to 0.25 mm, or 0.17 mm to 0.22 mm. In addition, a first interval (interval in the first direction) between the first pattern P1 and the second pattern P2 may be 0.1 mm to 0.3 mm, 0.15 mm to 0.25 mm, or 0.17 mm to 0.22 mm. In addition, a second interval (interval in the second direction) between the first pattern P1 and the second pattern P2 may be 0.01 mm to 0.2 mm, 0.05 mm to 0.15 mm, or 0.07 mm to 0.12 mm.

At least one first pattern among the plurality of first patterns P1 opens an end region of the elastic member. In detail, at least one first pattern opens an end region of the elastic member facing in the first direction 1D.

A hinge part HN is formed by the first pattern P1 opening the end region of the elastic member.

The elastic member 100 can be easily folded by the hinge part HN. That is, the hinge part HN is a point where folding of the first region 1A starts.

The first region 1A and the second region 2A are defined by the pattern part PA1 and PA2. In detail, the first region 1A is a region from the point where the pattern part PA1 and PA2 starts to the point where the pattern part PA1 and PA2 ends. In addition, the second region 2A is a region other than the first region 1A.

Alternatively, the first region 1A is a region from a first pattern part PA1 and PA2 to a last pattern part PA1 and PA2 among the plurality of pattern parts PA1 and PA2. In addition, the second region 2A is a region other than the first region 1A.

Alternatively, the first region 1A is a region from a first hinge part HN to a last hinge part HN. In addition, the second region 2A is a region other than the first region 1A.

The third pattern parts PA3 are spaced apart in the second direction 2D. In addition, the fourth pattern parts PA4 are spaced apart in the second direction 2D. In addition, the third pattern part PA3 and the fourth pattern part PA4 are spaced apart in the second direction 2D.

The third pattern P3 and the fourth pattern P4 face each other in the second direction 2D. For example, the third pattern P3 and the fourth pattern P4 partially overlap each other in the second direction 2D.

The third pattern P3 and the fourth pattern P4 are formed by penetrating the elastic member 100. For example, the third pattern P3 and the fourth pattern P4 completely penetrate the elastic member 100. Accordingly, the third pattern P3 and the fourth pattern P4 may be formed in a hole shape. Alternatively, the third pattern P3 and the fourth pattern P4 partially penetrate the elastic member 100. Accordingly, the first pattern P3 and the fourth pattern P4 may be formed in a groove shape.

A size of the third pattern P3 may change as it moves away from the first region 1A, an outermost first pattern part PA1, or an outermost hinge part HN. In detail, the size of the third pattern P3 may decrease as it moves away from the first region 1A, the outermost first pattern part PA1, or the outermost hinge part HN.

Referring to FIG. 11, a length of the third pattern P3 may decrease as it moves away from the first region 1A, the outermost first pattern part PA1, or the outermost hinge part HN. Alternatively, the width of the third pattern P3 may decrease as it moves away from the first region 1A, the outermost first pattern part PA1, or the outermost hinge part HN. Alternatively, an interval between the third patterns P3 may increase as it moves away from the first region 1A, the outermost first pattern part PA1, or the outermost hinge part HN.

In addition, a minimum length of the third pattern P3 may be 1.0 mm to 5.0 mm, 1.5 mm to 3.0 mm, or 2.0 mm to 2.5 mm. In addition, a maximum interval between the third patterns P3 may be 0.5 mm to 2.5 mm, 1.0 mm to 2.0 mm, or 1.5 mm to 1.8 mm.

In addition, a minimum distance between an outermost side of the elastic member 100 and an outermost side of the third pattern P3 may be 1 mm to 10 mm, 2 mm to 8 mm, or 3.5 mm to 7 mm. In addition, a maximum distance between an outermost side of the elastic member 100 and an outermost side of the third pattern P3 may be 5 mm to 20 mm, 6.5 mm to 15 mm, or 8 mm to 9 mm.

In addition, the width (width in the second direction) of the second-first region 2-1A may be 3 mm to 12 mm, 4.5 mm to 10.5 mm, or 6 mm to 8 mm.

In addition, the size of the fourth pattern P4 may change as it moves away from the first region 1A, the outermost first pattern part PA1, or the outermost hinge part HN. In detail, the size of the fourth pattern P4 may decrease as it moves away from the first region 1A, the outermost first pattern part PA1, or the outermost hinge part HN.

Referring to FIG. 11, a length of the fourth pattern P4 may decrease as it moves away from the first region 1A, the outermost first pattern part PA1, or the outermost hinge part HN. Alternatively, the width of the fourth pattern P4 may decrease as it moves away from the first region 1A, the outermost first pattern part PA1, or the outermost hinge part HN. Alternatively, an interval between the fourth patterns P4 may increase as it moves away from the first region 1A, the outermost first pattern part PA1, or the outermost hinge part HN.

In addition, a minimum length of the fourth pattern P4 may be 1.0 mm to 5.0 mm, 1.5 mm to 3.0 mm, or 2.0 mm to 2.5 mm. In addition, a maximum interval between the fourth patterns P4 may be 0.5 mm to 2.5 mm, 1.0 mm to 2.0 mm, or 1.5 mm to 1.8 mm.

In addition, a minimum distance between an outermost side of the elastic member 100 and an outermost side of the fourth pattern P4 may be 1 mm to 10 mm, 2 mm to 8 mm, or 3.5 mm to 7 mm. In addition, a maximum distance between an outermost side of the elastic member 100 and an outermost side of the fourth pattern P4 may be 5 mm to 20 mm, 6.5 mm to 15 mm, or 8 mm to 9 mm.

That is, the third pattern part PA3 and the fourth pattern part PA4 may include patterns having different sizes depending on a location. That is, the third pattern part PA3 and the fourth pattern part PA4 may include a gradation pattern. Accordingly, it is possible to prevent a pattern from being recognized at a boundary between the first region 1A and the second-second region 2-2A.

If the third pattern part PA3 and the fourth pattern part PA4 are not present, a boundary region of the first region and the second-second region can be recognized from an outside. However, the third pattern part PA3 and the fourth pattern part PA4 are disposed in the second-first region. In addition, sizes of the third pattern part PA3 and the fourth pattern part PA4 change. Therefore, a boundary region of the first region and the second-second region can be prevented from being recognized from the outside.

The elastic member 100 includes a cutting region CA, and the cutting region CA is a region where the elastic member 100 and the bridge part BR are cut.

The cutting region CA is disposed in the second region 2A.

The cutting region CA has a set size. In detail, a width of the cutting region CA is larger than an interval in the first direction of the first and second patterns of the first region. In addition, the width of the cutting region CA is smaller than the length of the first and second patterns.

In addition, the width of the cutting region CA is larger than the width of the first and second patterns of the first region. In addition, the width of the cutting region CA is smaller than the minimum length of the third and fourth patterns of the second-first region.

In addition, the width of the cutting region CA may be larger than five times the width of the first and second patterns. In addition, the width of the cutting region CA may be smaller than the maximum interval in the second direction of the third and fourth patterns of the second-first region.

Accordingly, folding characteristics of the elastic member are improved by the cutting region CA. If the width of the cutting region CA is larger than the length of the first and second patterns, the width of the cutting region increases. Accordingly, a region overlapping the first and second patterns in the first direction 1D may not be folded during a folding test or a process of manufacturing the elastic member. Accordingly, a part of the second-first region overlapping the cutting region in the first direction may not function as a boundary region. In addition, the elastic member may be damaged due to the stress concentration caused by rapid folding.

In addition, if the width of the cutting region CA is smaller than the interval of the first and second patterns in the first direction, a protruding part may be broken during a folding test or a process of manufacturing the elastic member.

The cutting region CA includes a cutting surface CS, a first concave portion C1, and a second concave portion C2.

The cutting surface CS is a surface on which the elastic member 100 is cut from the bridge part BR. Accordingly, a surface roughness and shape of the cutting surface CS and a surface roughness and shape of the outer surface OS may be different.

For example, the surface roughness of the cutting surface CS and the surface roughness of the outer surface OS may be different. In detail, the surface roughness of the cutting surface CS may be greater than the surface roughness of the outer surface OS.

In addition, the cutting surface CS may include an inclined surface. In addition, the cutting surface CS may include a curved surface.

In addition, the first concave portion C1 and the second concave portion C2 may be concave with respect to the outer surface OS of the elastic member 100.

The first concave portion C1 and the second concave portion C1 may have set sizes. In detail, the first concave portion C1 has a first width W1. The second concave portion C2 has a second width W2.

The first width W1 and the second width W2 may be 30% or less of the width of the cutting region CA. In detail, the first width W1 and the second width W2 may be 15% to 30%, 18% to 28%, or 23% to 27% of the width of the cutting region CA.

The first width W1 and the second width W2 may be the same or similar within the above range.

If the first width W1 and the second width W2 exceed 30% of the width of the cutting region CA, a region where the connection part CP and the bridge part BR are connected decreases. As a result, the bonding force between the elastic member 100 and the frame 200 decreases. Accordingly, when handling the elastic member 100, the elastic member 100 and the frame 200 may be separated.

If the first width W1 and the second width W2 are less than 15% of the width of the cutting region CA, the widths of the first width W1 and the second width W2 decrease. Accordingly, when cutting the connection part CP, a region other than the connection part CP may be cut. Accordingly, the reliability of the elastic member 100 decreases.

In addition, the first width W1 and the second width W2 may be smaller than 1/3 of the width of the cutting region. Alternatively, the first width W1 and the second width W2 may be larger than the interval of the first and second patterns in the first direction. In addition, the first width W1 and the second width W2 may be smaller than the lengths of the first and second patterns. Alternatively, the first width W1 and the second width W2 may be larger than the widths of the first and second patterns. In addition, the first width W1 and the second width W2 may be smaller than the minimum lengths of the third and fourth patterns. Alternatively, the first width W1 and the second width W2 may be larger than the widths of the first and second patterns. In addition, the first width W1 and the second width W2 may be smaller than the maximum interval of the third and fourth patterns in the second direction.

Accordingly, the folding characteristic of the elastic member is improved by the cutting region CA. If the width of the cutting region CA is larger than the length of the first and second patterns, the width of the cutting region becomes larger. Accordingly, a region overlapping the first and second patterns in the first direction 1D may not be folded during the folding test or the process of manufacturing the elastic member. Accordingly, a part of the second-first region overlapping the cutting region in the first direction may not function as a boundary region. In addition, the elastic member may be damaged due to the stress being concentrated due to rapid folding.

In addition, if the width of the cutting region CA is smaller than the interval in the first direction of the first and second patterns, a protruding part may be broken during the folding test or the process of manufacturing the elastic member.

The height H1 and H2 of the concave portion C1 and C2 and the third height may be the same or different. The third height H3 is a height from the bottom surface BS of the concave portion C1 and C2 to the cutting surface. That is, as shown in FIG. 10, the height H1 and H2 of the concave portion C1 and C2 may be the same as the third height H3. Alternatively, the height H1 and H2 of the concave portion C1 and C2 may be different from the third height H3.

In detail, the first height H1 may be a depth of the concave portion C1 and C2. That is, the first height H1 is a distance in the first direction from an innermost side of the concave portion C1 and C2 to the outer surface OS of the elastic member.

The third height H3 may be less than or equal to the first and second heights H1 and H2. That is, the outer surface OS protrudes outwardly from the elastic member more than the cutting surface CS. Accordingly, the cutting surface CS may be disposed on a same plane as the outer surface OS. Alternatively, the cutting surface CS may be disposed at an inner side than the outer surface OS. That is, the cutting surface CS and the outer surface OS have a step SH. In addition, the cutting surface CS may be disposed at an inner side of the elastic member more than the outer surface OS.

Therefore, when a user handles the elastic member, it is possible to prevent the user from coming into contact with the cutting surface CS. Accordingly, the user's safety is improved. In addition, the cutting surface CS does not protrude outwardly from the outer surface OS. This can prevent a bezel region of the elastic member from increasing.

In addition, the first and second heights H1 and H2 may be greater than 0.1 times the interval of the first and second patterns in the first direction. In addition, the first and second heights H1 and H2 may be less than twice the interval in the second direction of the first and second patterns. Alternatively, the first and second heights H1 and H2 may be greater than 0.5 times the interval of the first and second patterns in the first direction. In addition, the first and second heights H1 and H2 may be less than the interval of the first and second patterns in the second direction.

Accordingly, the folding characteristic is improved. If the first and second heights H1 and H2 are greater than twice the interval in the second direction of the first and second patterns, sizes of the first and second patterns, which are engraved shapes, increases. Accordingly, the first and second patterns may function as hinge parts. Accordingly, folding may occur in an undesired region. In addition, if the first and second heights H1 and H2 are less than 0.1 times the interval in the first direction of the first and second patterns, a stability problem may occur due to the remaining protruding part when performing a folding test or manufacturing an elastic member. In addition, the bezel region may increase.

In addition, a step SH between the cutting surface CS and the outer surface OS may be smaller than the first and second heights. Alternatively, the step SH may be greater than 0.1 times the interval in the first direction of the first and second patterns. In addition, the step SH may be smaller than the interval in the second direction of the first and second patterns. Alternatively, the step SH may be larger than 0.5 times the interval in the first direction of the first and second patterns. In addition, the step SH may be smaller than 0.7 times the interval in the second direction of the first and second patterns.

Accordingly, the folding characteristics are improved. If the step SH is greater than the first and second heights, a stability problem may occur due to the remaining protruding part when performing a folding test or manufacturing an elastic member. In addition, the bezel region may increase. In addition, if the step is less than 0.1 times the interval in the first direction of the first and second patterns, the size of the engraved shapes of the first and second patterns increases. Therefore, the first and second patterns may function as hinge parts. Accordingly, folding may occur in an undesired region.

Hereinafter, an elastic member according to another embodiment will be described with reference to FIGS. 5, 12 to 16. Descriptions identical to or similar to those of the previously described embodiments will be omitted.

As described in FIG. 5, when force is applied to one region of the bridge part BR, the bridge part BR is cut, and accordingly, the elastic member 100 and the frame 200 are separated.

In order to easily cut the bridge part BR, a cutting region can be set in one region of the bridge part BR. Then, the cutting region can be etched to a set depth. Accordingly, a thickness of the cutting region can be smaller than a thickness of other regions. That is, the cutting region can be a groove formed in the bridge part BR.

A plurality of pattern parts can be formed in the elastic member. The pattern part is performed by a roll-to-roll process. Therefore, tension can be applied in a length direction of the elastic member.

Accordingly, the cutting region can be cut while a width of the groove-shaped cutting region increases. Accordingly, the elastic member can be separated from the frame before being applied to the display device.

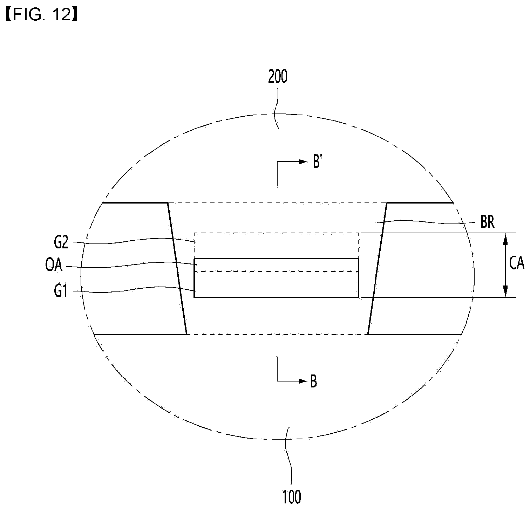

Referring to FIG. 12, the elastic member 100 and the frame 200 are connected by the bridge part BR.

The bridge part BR includes a cutting region CA. The cutting region CA includes a first groove G1 and a second groove G2. In detail, the bridge part BR includes one surface and other surface opposite to the one surface. The one surface corresponds to one surface of the elastic member. The other surface corresponds to the other surface of the elastic member.

The first groove G1 is disposed on one surface of the bridge part BR. That is, the first groove G1 is formed by etching the one surface. In addition, the second groove G2 is disposed on the other surface of the bridge part BR. That is, the second groove G2 is formed by etching the other surface.

In addition, the cutting region CA includes an overlapping region OA. The overlapping region OA is a region where the first groove G1 and the second groove G2 overlap. In detail, the first groove G1 and the second groove G2 overlap in the first direction 1D at the cutting region CA. That is, the first groove G1 and the second groove G2 overlap in the width direction of the elastic member 100 at the cutting region CA.

The first groove G1 and the second groove G2 have set widths and heights. In detail, the first groove G1 has a first width W1 and a first height H1. The second groove G2 has a second width W2 and a second height H2.

At least one of the first width W1 and the second width W2 may be smaller than a thickness T of the bridge part BR. In detail, at least one of the first width W1 and the second width W2 may be 50% or less, 40% or less, or 30% or less of a thickness T of the bridge part BR. For example, at least one of the first width W1 and the second width W2 may be 25% to 50%, 30% to 45%, or 35% to 40% of the thickness T of the bridge part BR.

In addition, the first width W1 and the second width W2 may be the same or similar.

If at least one of the first width W1 and the second width W2 is less than 25% of the thickness T of the bridge part BR, a size of the cutting region CA may be reduced. Accordingly, the elastic member 100 is not easily separated by the cutting region.

In addition, if at least one of the first width W1 and the second width W2 exceeds 50% of the thickness T of the bridge part BR, a size of the cutting region CA may increase. Accordingly, since a size of the bridge part BR increases, a size of the elastic member module also increases. In addition, a region etched in the bridge part BR increases. Accordingly, a strength of the bridge part BR may decrease. Accordingly, when handling the elastic member module, the bridge part BR may be cut.

At least one of the first height H1 and the second height H2 may be smaller than the thickness T of the bridge part BR. In detail, at least one of the first height H1 and the second height H2 may be 50% or less, 40% or less, or 30% or less of the thickness T of the bridge part BR. For example, at least one of the first height H1 and the second height H2 may be 25% to 50%, 30% to 45%, or 35% to 40%.

In addition, the first height H1 and the second height H2 may be the same or similar.

If at least one of the first height H1 and the second height H2 is less than 25% of the thickness T of the bridge part BR, a region that is not etched by the first groove G1 and the second groove G2 increases. Accordingly, a large force is required when cutting the bridge part BR. Therefore, the elastic member 100 is not easily separated by the cutting region.

In addition, if at least one of the first height H1 and the second height H2 exceeds 50% of the thickness T of the bridge part BR, an etching region increases. Accordingly, a strength of the bridge part BR may decrease. Accordingly, when handling the elastic member module, the bridge part BR may be cut.

A height H3 of the overlapping region OA is smaller than the thickness T of the bridge part BR. The height H3 of the overlapping region OA may be defined as a maximum height of the overlapping region OA. The overlapping region OA may change in height while extending in the first direction.

In detail, the height H3 of the overlapping region OA may be 25% or less, 20% or less, or 15% or less of the thickness T of the bridge part BR. For example, the height H3 of the overlapping region OA may be 5% to 25%, 10% to 20%, or 15% to 18%.

If the height H3 of the overlapping region OA is less than 5% of the thickness T of the bridge part BR, the first groove G1 and the second groove G2 may be connected during a process of forming the first groove G1 and the second groove G2. Accordingly, a hole is formed in the cutting region CA. Accordingly, a strength of the bridge part BR may be reduced. Accordingly, when handling the elastic member module, the bridge part BR may be cut.

In addition, if the height H3 of the overlapping region OA exceeds 25% of the thickness T of the bridge part BR, a region remaining without being etched by the first groove G1 and the second groove G2 may increase. Accordingly, a large force is required when cutting the bridge part BR. Therefore, the elastic member 100 is not easily separated by the cutting region.

A pitch P of the first groove G1 and the second groove G2 may be smaller than the thickness T of the bridge part BR.

In detail, the pitch P of the first groove G1 and the second groove G2 may be 25% or less, 20% or less, or 15% or less of the thickness T of the bridge part BR. For example, the pitch P of the first groove G1 and the second groove G2 may be 10% to 25% or 15% to 20%.

If the pitch P of the first groove G1 and the second groove G2 is less than 10% of the thickness T of the bridge part BR, the first groove G1 and the second groove G2 may be connected during a process of forming the first groove G1 and the second groove G2. Accordingly, a hole is formed in the cutting region CA. Accordingly, a strength of the bridge part BR may be reduced. Accordingly, when handling the elastic member module, the bridge part BR may be cut.

In addition, if the pitch P of the first groove G1 and the second groove G2 exceeds 25% of the thickness T of the bridge part BR, the height of the overlapping region OA may increase. Accordingly, the bridge part remaining in the overlapping region OA may increase. Accordingly, a large force is required when cutting the bridge part BR. Therefore, the elastic member 100 is not easily separated by the cutting region.

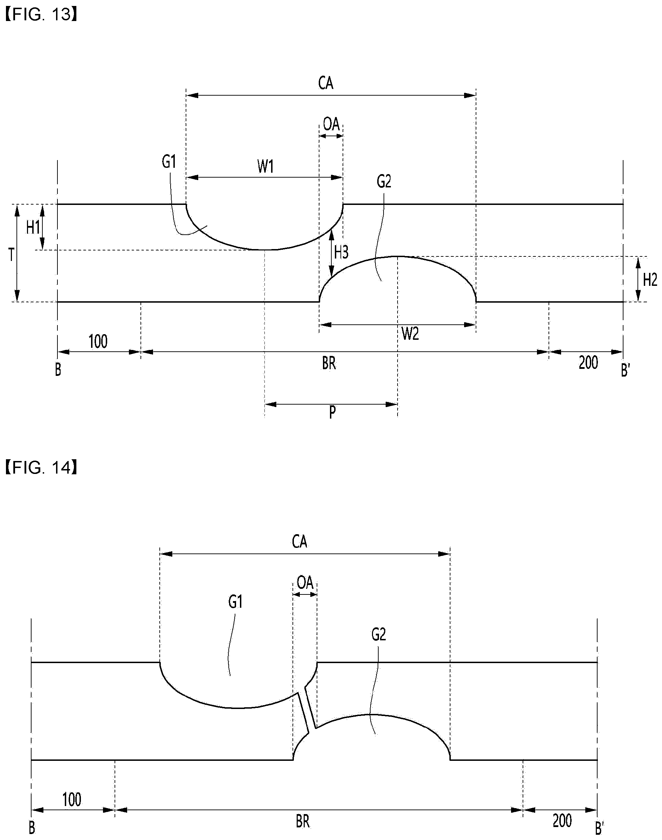

Referring to FIG. 14, the bridge part BR is cut in the cutting region CA. In detail, the bridge part BR is cut in one region of the cutting region CA. More specifically, the bridge part BR is cut in the overlapping region OA of the cutting region CA.

That is, the bridge part BR can be cut in a cutting region having a small height.

The elastic member module according to the embodiment has improved reliability. In detail, the bridge part includes a plurality of grooves that overlap each other. In detail, the bridge part includes a first groove and a second groove that are formed on each surface of the bridge part. In addition, the first groove and the second groove have a set height and width.

Accordingly, the width and height of the first groove and the second groove can be reduced. When the pattern part is formed by the roll-to-roll process, a tensile force is applied. The bridge part can be prevented from being broken by the tensile force in a region where the first groove and the second groove are formed.

In addition, when the first groove and the second groove are formed, a formation of a hole in the bridge part due to an error during the process can be prevented. Therefore, a defect of the elastic member module can be prevented.

In addition, the elastic member and the frame can be easily separated. In detail, the bridge part includes a plurality of grooves that overlap each other. The plurality of grooves form an overlapping region. Accordingly, the bridge part includes an overlapping region having a set height.

Therefore, even if the height and width of the first groove and the second groove are reduced, the bridge part is easily cut by the overlapping region. Therefore, the elastic member and the frame can be easily separated.

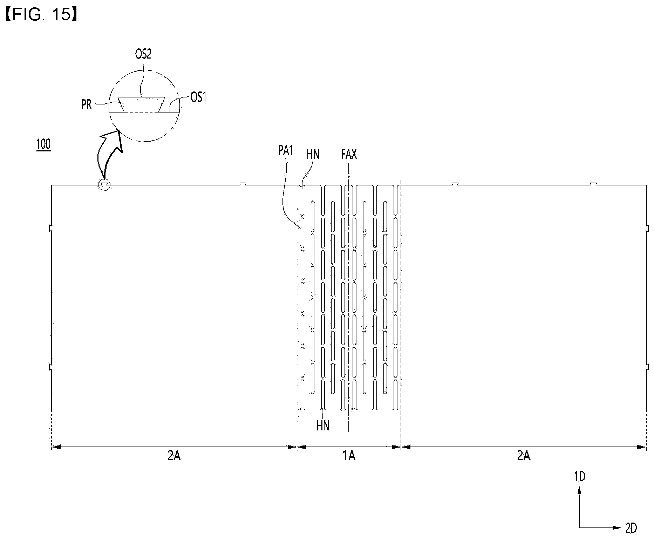

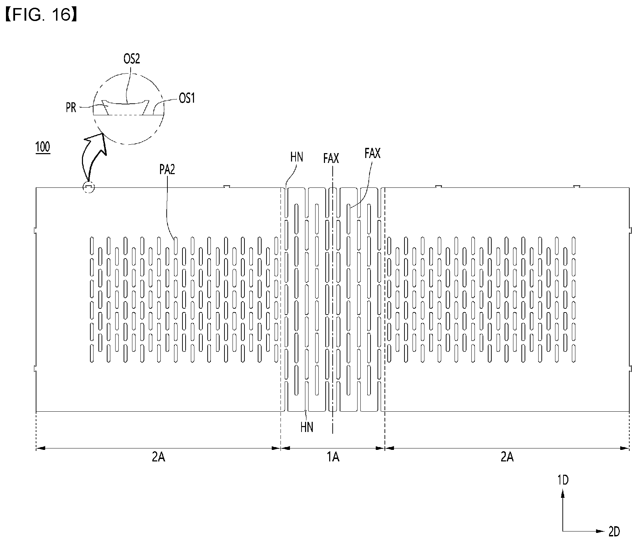

Referring to FIGS. 15 and 16, the elastic member 100 may include a first region 1A which is a folding region and a second region 2A which is an unfolding region.

Referring to FIG. 15, the elastic member 100 includes a plurality of pattern parts PA. For example, the plurality of pattern parts are formed by a roll-to-roll process. As described above, the bridge part includes a first groove, a second groove, and an overlapping region having a set size. Therefore, when forming the pattern part on the elastic member, the elastic member and the frame can be prevented from being separated.

The elastic member 100 may include a first pattern part PA1 disposed in the first region 1A.

In addition, referring to FIG. 16, the elastic member 100 may further include a second pattern part PA2. In detail, the elastic member 100 may further include a second pattern part PA2 disposed in the second region 2A.

The elastic member 100 includes a plurality of protruding parts PR.

The protruding parts PR are disposed in the second region 2A. In detail, the protruding parts PR protrude from an edge of the second region 2A of the elastic member.

The protruding parts PR are formed when the elastic member 100 and the frame 200 are separated. That is, the protruding parts PR may be a part of the bridge part. Accordingly, the protruding part PF is formed integrally with the elastic member 100.

The protruding part PR can control a position of the elastic member 100. In detail, when the elastic member 100 is applied to the display device 10, a position of the elastic member 100 can be controlled by the protruding part PR. That is, the elastic member 100 can be aligned by the protruding part PR. That is, the protruding part PR can be an alignment mark.

Therefore, the elastic member 100 does not require a separate alignment mark. Accordingly, the process efficiency for manufacturing the elastic member can be improved. In addition, a non-effective region of the elastic member can be prevented from increasing due to the alignment mark.

The outer surface OS1 of the elastic member and the outer surface OS2 of the protruding part PR can have different characteristics.

In detail, the outer surface OS1 of the elastic member and the outer surface OS2 of the protruding part PR can have different surface roughnesses. For example, the surface roughness of the outer surface OS2 of the protruding part PR can be greater than the surface roughness of the outer surface OS1 of the elastic member. The outer surface OS2 of the protruding part PR is a region where the bridge part is cut. Therefore, the surface roughness of the outer surface OS2 of the protruding part PR can be greater than the surface roughness of the outer surface OS1 of the elastic member. However, the embodiment is not limited thereto. The surface roughness of the outer surface OS2 of the protruding part PR may be smaller than the surface roughness of the outer surface OS1 of the elastic member.

In addition, the outer surface OS1 of the elastic member and the outer surface OS2 of the protruding part PR may have different shapes. For example, the outer surface OS1 of the elastic member and the outer surface OS2 of the protruding part PR may have different curvatures.

In detail, the curvature of the outer surface OS2 of the protruding part PR may be greater than the curvature of the outer surface OS1 of the elastic member. For example, the outer surface OS2 of the protruding part PR is formed in a curved shape. In addition, the outer surface OS1 of the elastic member is formed in a flat shape. Alternatively, the outer surface OS2 of the protruding part PR is formed in a curved shape with a large curvature. In addition, the outer surface OS1 of the elastic member may be formed in a curved shape with a small curvature.

In addition, an inclination angle of the outer surface OS1 of the elastic member may be different from an inclination angle of the outer surface OS2 of the protruding part PR. For example, the inclination angle of the outer surface OS1 of the elastic member may be greater than the inclination angle of the outer surface OS2 of the protruding part PR.

The outer surface OS2 of the protruding part PR is a region where the bridge part is cut. Therefore, the curvature or inclination angle of the outer surface OS2 of the protruding part PR may be greater than the curvature or inclination angle of the outer surface OS1 of the elastic member.

Accordingly, a position of the protruding part can be easily confirmed. A plurality of protruding parts may have different sizes. A protruding part having a small size may be difficult to distinguish from the outer surface of an edge of the elastic member.

Accordingly, the surface roughness or shape of the outer surface OS1 of the elastic member and the outer surface OS2 of the protruding part PR are formed differently. Therefore, even if the size of the protruding part is reduced, a position of the protruding part can be easily confirmed. Therefore, a position of the elastic member is easily aligned by the protruding part.

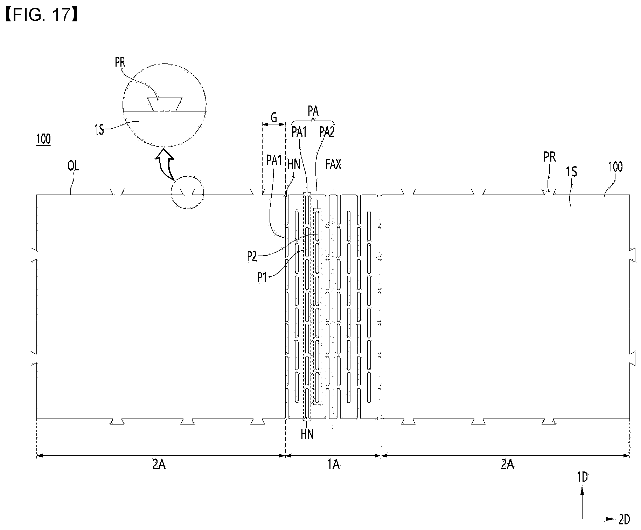

Hereinafter, an elastic member according to another embodiment will be described with reference to FIGS. 17 to 25. Descriptions identical to or similar to those of the previously described embodiment will be omitted.

FIG. 17 is a drawing showing a top view of an elastic member according to an embodiment.

The elastic member 100 includes a plurality of protruding parts PR. In detail, the plurality of protruding parts PR are disposed at an edge OL of the elastic member 100. The protruding part PR protrudes outward from the edge OL.

The protruding part PR is formed while separating the elastic member 100 and the frame 200.

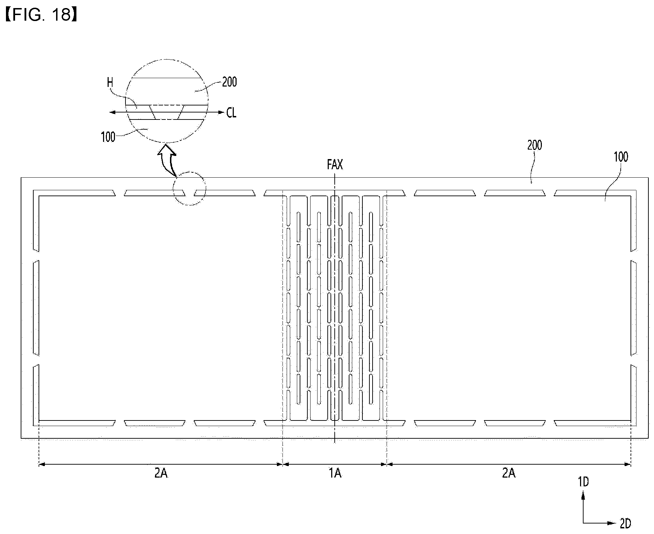

Referring to FIG. 18, the elastic member 100 is combined with the frame 200 before being applied to the display device.

In detail, the elastic member 100 and the frame 200 are connected by the bridge part BR while being separated by the hole H. The elastic member 100 and the frame 200 are separated by the cutting region CL of the bridge part BR.

The protruding part PR is formed by a remaining bridge part.

The protruding part PR is separated from an end of the first region 1A. In detail, the protruding part PR is separated from a first pattern part PA1 disposed at an outermost side in the second direction 2D. In detail, the protruding part PR is separated from a hinge part HN disposed at an outermost side in the second direction 2D.

A distance G between the protruding part most adjacent to the first pattern part PA1 at the outermost side and the first pattern part PA1 at the outermost side has a set size. That is, the distance G between a protruding part most adjacent to an outermost hinge part HN and the outermost hinge part HN has a set size.

The distance G may exceed 0. That is, the protruding part does not contact the first pattern part or the hinge part. The distance G may be 5 mm or less. That is, the distance G may be greater than 0 and smaller than or equal to 5 mm.

When the distance G satisfies the above range, a deformation of the pattern part is reduced. That is, a deformation of an interval between the first pattern parts PA1 may be reduced by the distance G. Alternatively, a deformation of an interval between the second pattern parts PA2 may be reduced by the distance G. Alternatively, a deformation of an interval between the first pattern part PA1 and the second pattern part PA may be reduced by the distance G. Alternatively, a deformation of an interval between the first patterns P1 may be reduced by the distance G. Alternatively, a deformation of an interval between the second patterns P2 may be reduced by the distance G. Alternatively, a deformation of the width and length of the first pattern P1 may be reduced by the distance G. Alternatively, a deformation of the width and length of the second pattern P2 may be reduced by the distance G of the protruding part.

In addition, if the distance G is out of the range, the deformation of the pattern part may be increased. That is, if the distance G exceeds 5 mm, the deformation of the interval between the first pattern parts PA1, the deformation of the interval between the second pattern parts PA2, the deformation of the interval between the first pattern part PA1 and the second pattern parts PA, the deformation of the interval between the first patterns P1, the deformation of the interval between the second patterns P2, the deformation of the width and length of the first pattern P1 or the width and length of the second pattern P2 may increase due to the distance G.

Alternatively, the distance G may be equal to or greater than the interval in the second direction 2D of the pattern P1 and P2 and less than or equal to three times a maximum length of the pattern. Alternatively, the distance G may be equal to or greater than a minimum width of the pattern P1 and P2 and less than or equal to twice a maximum length of the pattern. Alternatively, the distance G may be equal to or greater than the interval in the second direction 2D of the pattern P1 and P2 and less than or equal to a maximum length of the pattern. Alternatively, the distance G may be equal to or greater than twice the interval in the second direction 2D of the pattern P1 and P2 and less than or equal to ten times the interval in the second direction 2D of the pattern. Alternatively, the distance G may be equal to or greater than the width of the protruding part PR.

The protruding part PR is formed by the bridge part BR. The elastic member 100 and the frame 200 are connected by the bridge part BR. In addition, sagging of the elastic member 100 is reduced by the bridge part BR.

In detail, when the elastic member module is bent in one direction, the elastic member and the frame are also bent in a same direction. An area of the elastic member is larger than an area of the frame. Therefore, the elastic member can be bent more than the frame. Accordingly, the first region of the elastic member can be sagging in one direction. When the sagging increases, stress applied to the first region increases. In addition, deformation may occur in the pattern part and the pattern.

Therefore, the bridge part and the protruding part can be close to the outermost first pattern part or the outermost hinge part by a set size. Accordingly, the sagging of the first region can be reduced. That is, when the first region is sagging, the bridge part can play a role in fixing the first region.

In addition, the stress generated when the elastic member module is bent is effectively distributed. That is, stress is generated when the elastic member module is bent. The stress is transferred to the frame through the bridge part. Since the stress is distributed, it is possible to prevent stress from being concentrated on one region of the elastic member. Accordingly, it is possible to prevent the waviness of a surface of the elastic member from increasing. Accordingly, a surface of the elastic member is flattened.

In addition, since the bridge part and the protruding part are disposed close to the outermost first pattern part or the outermost hinge part by a set size, numbers of bridge parts and protruding parts disposed at an edge of the first direction 1D of the elastic member can be increased.

The pattern is formed by a roll-to-roll process. Accordingly, the elastic member module is wound around a roller in the second direction. Accordingly, when the roll-to-roll process is performed, a tensile force can be generated in the second direction. The bridge part can be broken by the tensile force. When a plurality of bridge parts are broken, the bonding force between the elastic member and the frame decreases. Accordingly, the elastic member may be separated from the frame during a process of forming the pattern. Since the numbers of the bridge parts and the protruding parts increases, a region where the elastic member and the frame are connected increases. Accordingly, the elastic member and the frame can be prevented from being separated during the roll-roll process.

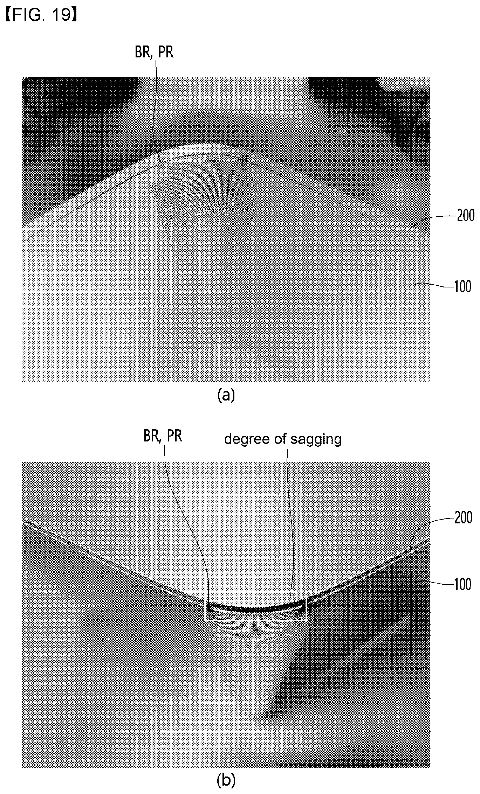

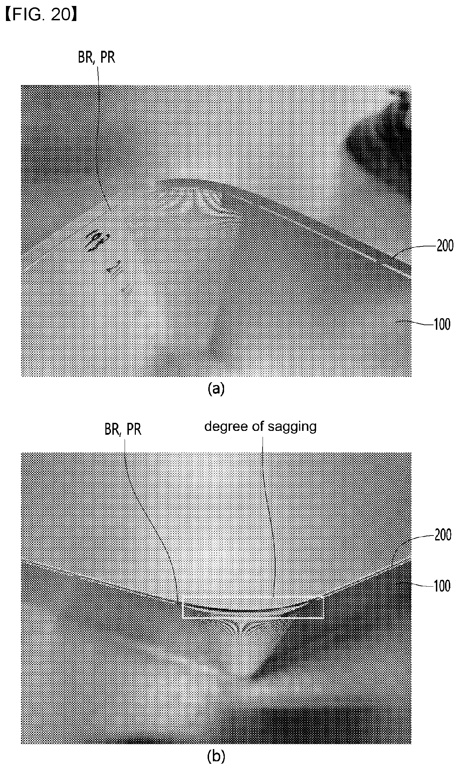

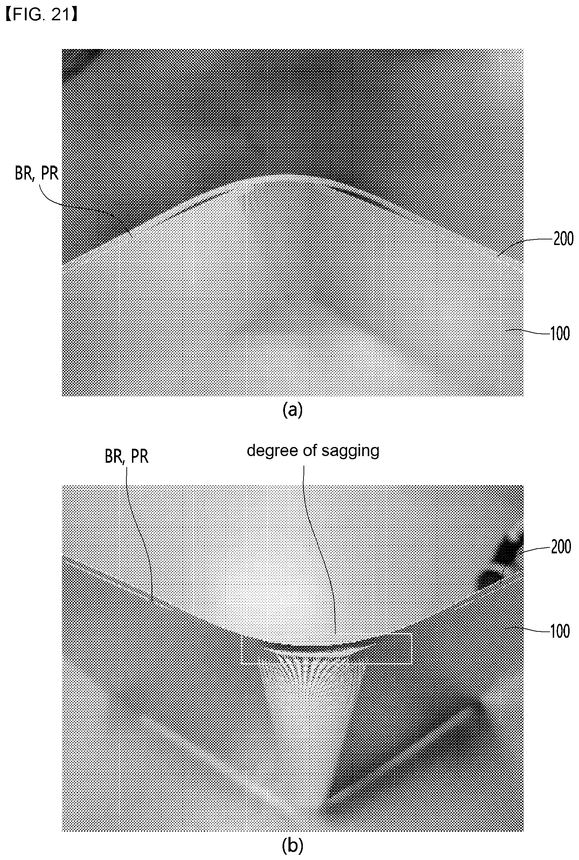

FIGS. 19 to 21 are drawings for explaining the deformation of the pattern according to a position of the protruding part. FIG. 19 is a drawing when the distance G is 5 mm or less. (a) is a drawing of a folding inner surface. (b) is a drawing of a folding outer surface. FIG. 20 is a drawing when the distance G exceeds 5 mm and less than or equal to 10 mm. (a) is a drawing of a folding inner surface. (b) is a drawing of a folding outer surface. FIG. 21 is a drawing when the distance G exceeds 10 mm. (a) is a drawing of an folding inner surface. (b) is a drawing of a folding outer surface.

Referring to FIG. 19, when the elastic member module is bent, the sagging of the first region due to the protruding part is small. That is, the protruding part PR plays a role in fixing the first region. Therefore, the sagging of the first region is reduced. Therefore, the deformation of the pattern part and the pattern is reduced.

Referring to FIG. 20, when the elastic member module is bent, the sagging of the first region is greater than that in FIG. 19. That is, since the protruding part PR is positioned far from the first region, it is difficult to fix the first region with the protruding part. Therefore, the deformation of the pattern part and the pattern may increase.

Referring to FIG. 21, when the elastic member module is bent, the sagging of the first region is greater than that in FIG. 19 and FIG. 20. That is, since the protruding part PR is positioned far from the first region, it is difficult to fix the first region with the protruding part. Therefore, the deformation of the pattern part and the pattern may increase.

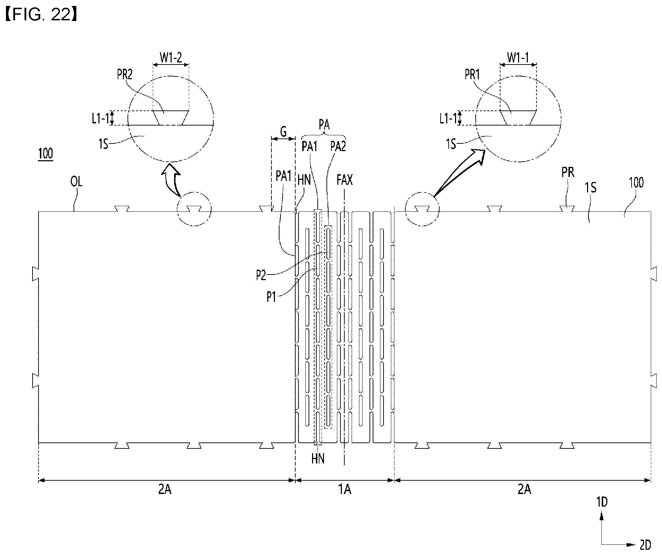

Hereinafter, an elastic member according to another embodiment will be described with reference to FIG. 22.

Referring to FIG. 22, the elastic member 100 includes a first protruding part PR1 and a second protruding part PR2. The first protruding part PR1 is a protruding part that is closest to the first region 1A. Alternatively, the first protruding part PR1 is a protruding part that is closest to the outermost first pattern part PA1. Alternatively, the first protruding part PR1 is a protruding part that is closest to the outermost hinge part HN. In addition, the second protruding part PR2 is a protruding part other than the first protruding part PR1.

The distance G between the first protruding part PR1 and the outermost first pattern part PA1 or the distance G between the first protruding part PR1 and the outermost hinge part HN may be greater than 0 and smaller than or equal to 5 mm.

The first protruding part PR1 and the second protruding part PR2 have different sizes. In detail, a length L1-1 of the first protruding part PR1 may be different from a length L1-2 of the second protruding part PR2. Alternatively, a width W1-1 of the first protruding part PR1 may be different from a width WL1-2 of the second protruding part PR2. Alternatively, a length L1-1 of the first protruding part PR1 may be different from a length L1-2 of the second protruding part PR2, and a width W1-1 of the first protruding part PR1 may be different from a width WL1-2 of the second protruding part PR2. Alternatively, an area (L1-1*W1-1) of the first protruding part PR1 may be different from an area (L1-2*W1-2) of the second protruding part PR2.

In addition, the width of the first protruding part PR1 and the width of the second protruding part PR2 may be smaller than the length of the first pattern part PA1 and larger than the width of the first pattern part PA1. For example, the width of the first protruding part PR1 and the width of the second protruding part PR2 may be smaller than the length of the first pattern part PA1 and larger than two or three times the width of the first pattern part PA1.

If the width of the first protruding part PR1 and the width of the second protruding part PR2 is larger than the length of the first pattern part PA1, folding failure of the elastic member may occur. In addition, when folding, the hinge part adjacent to the first protruding part may be wider than the hinge part adjacent to the folding axis due to the first protruding part having a wide width adjacent to the hinge part. Accordingly, the widths of the hinge parts may vary.

In addition, if the widths of the first protruding part PR1 and the second protruding part PR2 are smaller than the widths of the first pattern part PA1, and the protruding part may be broken during the manufacturing process of the elastic member or during the folding test of the elastic member.

For example, the size of the first protruding part PR1 may be larger than the size of the second protruding part PR2. In detail, the area of the first protruding part PR1 may be larger than the area of the second protruding part PR2. For example, when forming the bridge part, the width or length of the bridge part corresponding to the first protruding part PR1 can be formed to be larger than the width of the bridge part corresponding to the second protruding part PR2. Accordingly, after separating the elastic member and the frame, the area of the first protruding part PR1 can be made larger than the area of the second protruding part PR2.

Since the area of the first protruding part PR1 is formed to be larger than the area of the second protruding part PR2, the sagging of the first region can be reduced. That is, since the area of the first protruding part PR1 increases, the fixing force of the first protruding part PR1 fixing the first region can be increased. Therefore, since the sagging of the first region is reduced, the deformation of the pattern part and the pattern can be reduced.

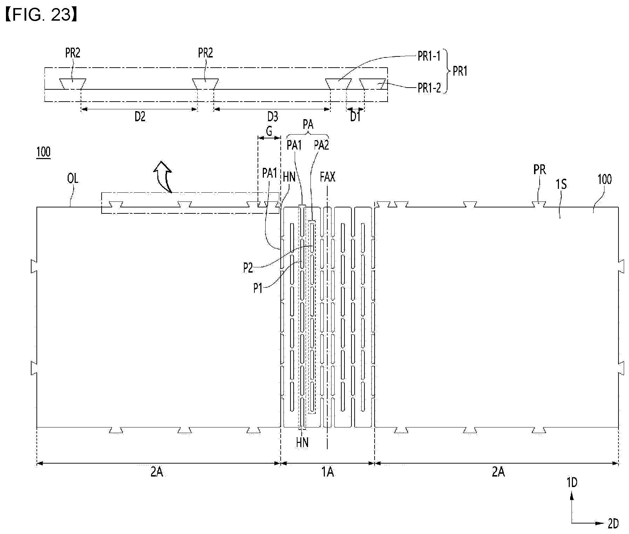

Referring to FIG. 23, the elastic member 100 includes a first protruding part PR1 and a second protruding part PR2. The first protruding part PR1 is a protruding part whose distance from the first region 1A is within 5 mm. Alternatively, the first protruding part PR1 is a protruding part whose distance from the outermost first pattern part PA1 is within 5 mm. Alternatively, the first protruding part PR1 is a protruding part whose distance from the outermost hinge part HN is within 5 mm. In addition, the second protruding part PR2 is a protruding part other than the first protruding part PR1.

The first protruding part PR1 includes a plurality of protruding parts. For example, the first protruding part PR1 includes a first-first protruding part PR1-1 and a first-second protruding part PR1-2. In detail, a plurality of protruding parts having a distance of less than 5 mm from the first region 1A, the outermost first pattern part PA1 or the outermost hinge part HN may be provided. In FIG. 23, two protruding parts are illustrated. However, the embodiment is not limited thereto, and three or more protruding parts may be disposed.

Since a plurality of protruding parts having a distance of less than 5 mm from the first region 1A, the outermost first pattern part PA1 or the outermost hinge part HN are disposed, the deformation of the interval between the first pattern parts PA1, the deformation of the interval between the second pattern parts PA2, the deformation of the interval between the first pattern part PA1 and the second pattern parts PA, the deformation of the interval between the first patterns P1, the deformation of the interval between the second patterns P2, the deformation of the width and length of the first pattern P1, and the deformation of the width and length of the second pattern P2 can be reduced.

In detail, the sagging of the first region can be reduced. That is, since the fixing force by the protruding part is increased, the first region can be effectively fixed when the first region is sagging.

In addition, the plurality of protruding parts can be disposed at different intervals. In detail, an interval between the protruding parts having a distance of less than 5 mm from the first region 1A, the outermost first pattern part PA1 or the outermost hinge part HN may be different from an interval between protruding parts having a distance of more than 5 mm from the first region 1A, the outermost first pattern part PA1 or the outermost hinge part HN. In detail, the interval between the protruding parts having a distance of less than 5 mm from the first region 1A, the outermost first pattern part PA1 or the outermost hinge part HN may be smaller than the interval between the protruding parts having a distance of more than 5 mm from the first region 1A, the outermost first pattern part PA1 or the outermost hinge part HN.

For example, an interval D1 between the first-first protruding part PR1-1 and the first-second protruding part PR1-2 may be smaller than an interval D2 between the second protruding part PR2. In addition, an interval D1 between the first-first protruding part PR1-1 and the first-second protruding part PR1-2 may be smaller than an interval D3 between the first-second protruding part PR1-2 and the second protruding part PR2.

That is, an interval between the protruding parts may increase as the protruding parts move away from the first region 1A, the outermost first pattern part PA1, or the outermost hinge part HN. In other words, the interval between the protruding parts may decrease as the protruding parts get closer to the first region 1A, the outermost first pattern part PA1, or the outermost hinge part HN.

Accordingly, when forming a pattern by a roll-to-roll process, the elastic member and the frame may be prevented from being separated. Specifically, when forming a pattern part in the first region of the elastic member, a force for etching is applied to the elastic member. Accordingly, the elastic member and the frame may be separated during the process of forming the pattern. Therefore, the interval between the bridge part and the protruding part is made small in a region adjacent to a region where the pattern part is formed. Accordingly, when forming a pattern in the elastic member, the elastic member and the frame may be prevented from being separated.

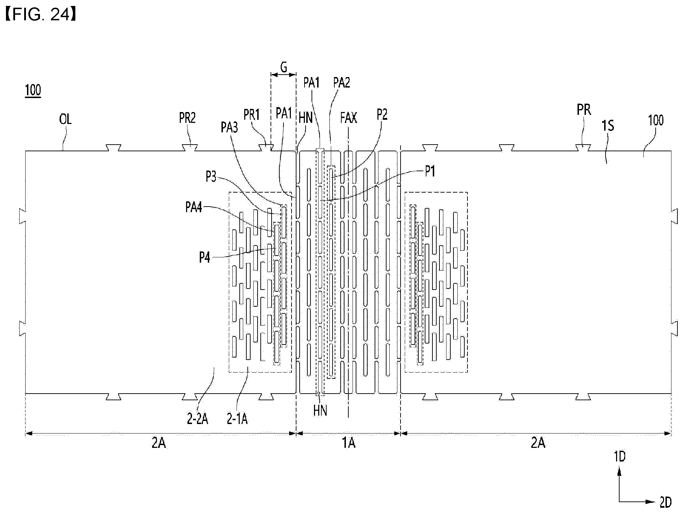

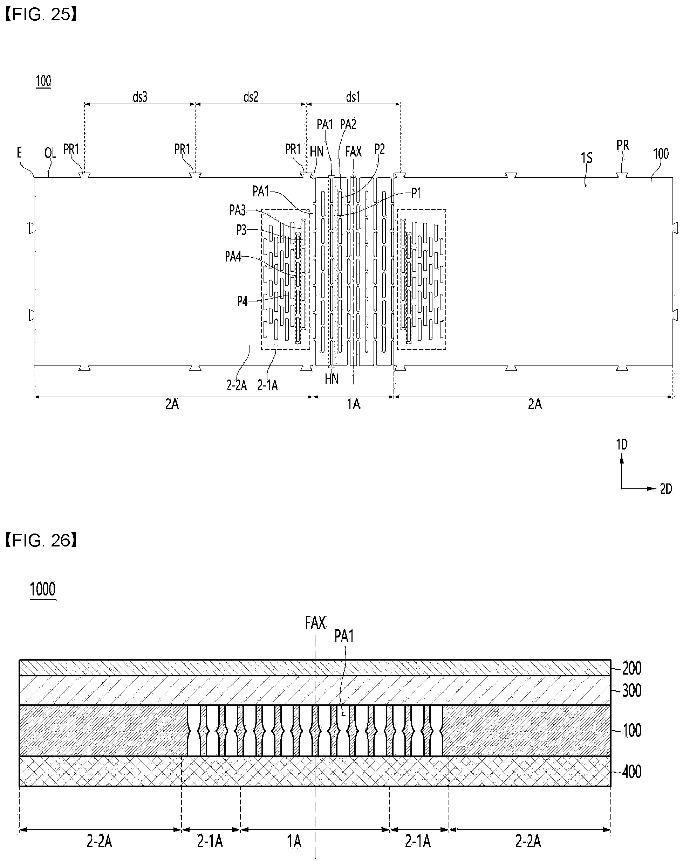

Referring to FIGS. 24 and 25, the elastic member may include a plurality of pattern parts. Specifically, a pattern part including a plurality of patterns may be disposed in the first region 1A and the second region 2A.

The protruding part PR includes a first protruding part PR1 and a second protruding part PR2. The first protruding part PR1 is a protruding part that is closest to the first region 1A, the outermost first pattern part PA1, or the outermost hinge part HN. In addition, the second protruding part PR2 is a protruding part other than the first protruding part PR1.

The first protruding part PR1 may overlap with the second-first region 2-1A. In detail, the first protruding part PR1 may overlap with the second-first region 2-1A in the first direction 1D.

In addition, the second protruding part PR2 may not overlap with the second-first region 2-1A. In detail, the second protruding part PR2 does not overlap the second-first region 2-1A in the first direction 1D. Since the first protruding part PR1 is disposed to overlap the second-first region 2-1A, an area of the second-first region 2-1A can be aligned. For example, the area of the second-first region 2-1A can be set based on a position of the first protruding part PR1. Therefore, it is possible to prevent the strength of the elastic member from decreasing due to an increase in an area of the second-first region 2-1A. In addition, it is possible to prevent the boundary of the first region and the second region from being recognized due to a decrease in the area of the second-first region 2-1A.

In addition, since the first protruding part PR1 overlaps with the second-first region 2-1A, the areas of the second-first regions 2-1A can be made similar. In detail, the areas of the second-first regions 2-1A disposed at left and right sides of the first region can be controlled based on the position of the first protruding part PR1. Accordingly, the areas of the second-first regions 2-1A can be made uniform. Accordingly, an opening ratio of the elastic member 100 can be prevented from being different in one region of the elastic member. Accordingly, the elastic member can be prevented from being bent in one direction due to a difference in the strength of the elastic member.

In addition, referring to FIG. 25, a distance ds1 between the first protruding parts PR1 at both ends of the first region can be smaller than a distance between other protruding parts. In detail, the distance ds1 between the first protruding parts PR1 facing each other in the second direction 2D may be smaller than the distance ds2 between the first protruding parts PR1 and the second protruding parts PR2 facing each other in the second direction 2D. In addition, the distance ds1 between the first protruding parts PR1 facing each other in the second direction 2D may be smaller than the distance ds3 between the second protruding parts PR2 facing each other in the second direction 2D. Accordingly, the sagging may be reduced.

In addition, the first protruding part PR1 overlaps the second-first region 2-1A in the first direction 1D. In detail, a distance from the folding axis FAX to the second protruding part PR1 is smaller than a distance from the folding axis FAX to an outermost pattern of the second-first region 2-1A. In addition, a distance from the folding axis FAX to a second protruding part PR1 may be larger than a distance from the folding axis FAX to the outermost pattern of the first region 1A.

In addition, an edge region (E) of the elastic member may include a curved surface. In addition, a distance between the edge region (E) and the second protruding part PR2 that is closest the edge region (E) in the first direction 1D may be smaller than a distance between the edge region (E) and the second protruding part PR2 that is closest to the edge region (E) in the second direction 2D. Accordingly, when folding the elastic member, the edge region can be prevented from sagging compared to the frame. Therefore, it is possible to prevent wear on the edge region during the manufacturing process or folding test of the elastic member.

Hereinafter, a folding support including an elastic member according to the embodiment described above will be described with reference to FIG. 26.

Referring to FIG. 26, the folding support may include an elastic member 100, a flattening layer 200, an adhesive layer 300, and a protective layer 400.

The flattening layer 200 may be disposed on the elastic member 100 to flatten a surface of the elastic member 100. As described above, a plurality of pattern parts in the shape of holes or grooves are formed in the elastic member 100, and the surface of the elastic member 100 may not be flat due to the pattern parts. Accordingly, when a panel or the like is directly bonded to the elastic member 100, an adhesive strength with the panel may be reduced due to surface characteristics of the elastic member 100.

Accordingly, the flattening layer 200 may be disposed on the elastic member 100 to flatten a bonding surface where the elastic member 100 is bonded to the panel.

The flattening layer 200 may include a metal or a non-metal. In detail, the flattening layer 200 may include a metal or a plastic.

The adhesive layer 300 may be disposed between the elastic member 100 and the flattening layer 200. The adhesive layer 300 may be disposed between the elastic member 100 and the flattening layer 200 to bond the elastic member 100 and the flattening layer 200.

For example, the adhesive layer 300 may include a pressure sensitive adhesive (PSA), but the embodiment is not limited thereto.

The protective layer 400 may be disposed below the elastic member 100.

The protective layer 400 may have a color. For example, the protective layer 400 may be formed in a black color.

The protective layer 400 may include metal particles. For example, the protective layer 400 may include copper particles. Accordingly, the thermal conductivity of the protective layer 400 may be improved, thereby dissipating heat generated in the display device through the protective layer 400.

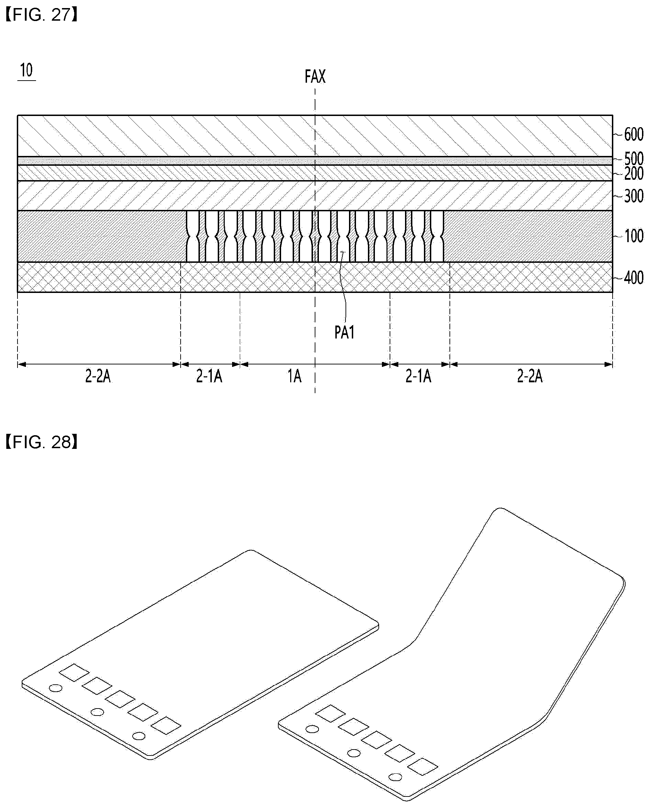

Hereinafter, with reference to FIG. 27, a display device including a folding support according to the embodiment described above will be described.

Referring to FIG. 27, the display device 10 may include a folding support and a panel.

The display device 10 may include the folding support and a panel layer 600 disposed on the folding support and including a display panel and/or a touch panel.

A bonding layer 500 is disposed between the elastic member 100 and the panel layer 600, and the elastic member 100 and the panel layer 600 may be bonded through the bonding layer 500.

As described above, since the elastic member 100 may be bonded to the bonding surface of the elastic member by the flattening layer 200, the elastic member and the panel layer may be stably bonded without the influence of a step.

The bonding layer 500 between the elastic member 100 and the panel layer 600 may have different characteristics from a third layer 300 of the elastic member 100.

In detail, the bonding layer 500 may have a thickness smaller than that of a third layer 300. For example, the thickness of the bonding layer 500 may be 5 µm to 15 µm.

FIG. 28 is a drawing for explaining an example in which an elastic member according to embodiments is applied.

Referring to FIG. 28, the elastic member according to embodiments may be applied to a flexible or foldable display device that displays a display.

For example, the elastic member according to embodiments may be applied to a flexible display device such as a mobile phone or tablet.

Such an elastic member may be applied to a flexible display device such as a mobile phone or tablet that is flexible, bent, or foldable.

The elastic member can be applied to a flexible display device such as a flexible, bent or foldable mobile phone or tablet, and can improve the folding reliability in a display device that is repeatedly folded or restored, thereby improving the reliability of the flexible display device.

The characteristics, structures, effects, and the like described in the above-described embodiments are included in at least one embodiment of the present invention, but are not limited to only one embodiment. Furthermore, the characteristic, structure, and effect illustrated in each embodiment may be combined or modified for other embodiments by a person skilled in the art. Accordingly, it is to be understood that such combination and modification are included in the scope of the present invention.

In addition, embodiments are mostly described above, but the embodiments are merely examples and do not limit the present invention, and a person skilled in the art may appreciate that several variations and applications not presented above may be made without departing from the essential characteristic of embodiments. For example, each component specifically represented in the embodiments may be varied. In addition, it should be construed that differences related to such a variation and such an application are included in the scope of the present invention defined in the following claims.

## Claims

1. An elastic member module comprising:
an elastic member and a frame,
wherein the elastic member and the frame are connected by a bridge part,
wherein the elastic member includes a cutting region,
wherein the cutting region includes a first concave portion, a second concave portion, and a connection part between the first concave portion and the second concave portion,
wherein the first concave portion and the second concave portion are formed in a concave shape with respect to an outer surface of the elastic member, and
wherein the connection part is connected to the bridge part.

2. The elastic member module of claim 1, wherein widths of the first concave portion and the second concave portion are 15% to 30% of a total width of the cutting region.

3. The elastic member module of claim 2, wherein heights of the first concave portion and the second concave portion are 20% to 40% of the width of the concave portion.

4. An elastic member including a first region and a second region, the elastic member comprising:
wherein the elastic member has a first direction defined in a width direction of the elastic member and a second direction defined in a length direction,
wherein the elastic member includes a cutting region,
wherein the cutting region includes a cutting surface and a concave portion including a first concave portion and a second concave portion,
wherein the first concave portion and the second concave portion are formed in a concave shape with respect to an outer surface of the elastic member,
wherein a first height from a bottom surface of the concave portion to the outer surface of the elastic member and a third height from a bottom surface of the concave portion to the cutting surface are defined, and
wherein the third height is less than or equal to the first height.

5. The elastic member of claim 4, wherein the cutting region is disposed in the second region.

6. The elastic member of claim 4, wherein a surface roughness of the cutting surface greater than a surface roughness of the outer surface of the elastic member.

7. The elastic member of claim 4, wherein the cutting surface includes a curved surface or an inclined surface.

8. The elastic member of claim 4, wherein widths of the first concave portion and the second concave portion are 15% to 30% of a total width of the cutting region.

9. An elastic member module comprising:
an elastic member and a frame,
wherein the elastic member and the frame are connected by a bridge part,
wherein the bridge part includes a cutting region,
wherein the cutting region includes a first groove formed on one surface of the bridge part and a second groove formed on an other surface opposite to the one surface of the bridge part,
wherein the cutting region includes an overlapping region in which the first groove and the second groove partially overlap in a width direction of the elastic member, and
wherein a height of the overlapping region is 5% to 25% of a thickness of the bridge part.

10. An elastic member including a first region and a second region, the elastic member comprising:
wherein the elastic member includes a first direction, which is a width direction, and a second direction, which is a length direction,
wherein the first region includes a plurality of first pattern parts including a plurality of first patterns spaced apart from each other in the first direction; and a plurality of second pattern parts including a plurality of second patterns spaced apart from each other in the first direction.
wherein the plurality of first pattern parts and the plurality of second pattern parts are alternately disposed,
wherein a first pattern disposed at an end in the first direction among the plurality of first patterns includes a hinge part disposed while opening one end region, and
wherein a plurality of protruding parts are disposed at an outermost side of the elastic member, and
wherein a distance between a protruding part most adjacent to an outermost hinge part among the plurality of protruding parts and the outermost hinge part is greater than 0 and smaller than or equal to 5 mm.
